# EUROPEAN PATENT APPLICATION

(11) **EP 4 708 008 A1**
(43) Date of publication of application: **11.03.2026**
(21) Application number: 24918377.3
(22) Date of filing: 31.12.2024
(51) Int. Cl.: G06F 3/042, H01L 25/16

(54) **OPTICAL SENSING MODULE AND ELECTRONIC DEVICE**

(30) Priority: 19.01.2024 CN 202420136479 U; 17.06.2024 CN 202410781766
(71) Applicant: Shenzhen Goodix Technology Co., Ltd., Shenzhen, Guangdong 518045 (CN)
(72) Inventor: LI, Jun, Shenzhen, Guangdong 518045 (CN); WEI, Ya, Shenzhen, Guangdong 518045 (CN)
(74) Representative: Kraus & Lederer PartGmbB
(86) International application number: PCT/CN2024/144442
(87) International publication number: WO 2025/152769

(57) **Abstract**

An optical sensing module and an electronic device are provided. The optical sensing module comprises: a substrate, a light shielding layer, one or more optical sensing chips, a light-transmitting layer, and a transparent conducting layer; the one or more optical sensing chips are arranged above the substrate; the light shielding layer clads a portion of the one or more optical sensing chips without contacting the substrate and the light-transmitting layer, and clads a portion of the light-transmitting layer that excludes a second surface of the light-transmitting layer and an area not in contact with the one or more optical sensing chips; the transparent conducting layer is in contact with the second surface of the light-transmitting layer, and is electrically connected to a ground wire in the substrate; and the transparent conducting layer is configured to shield an interference signal from the one or more optical sensing chips.

## Description

### CROSS-REFERENCE TO RELATED APPLICATIONS AND INCORPORATION BY REFERENCE

The present disclosure claims priority to patent application for utility model with the application No. 202420136479.0 filed on 19 January 2024 and titled "OPTICAL SENSING MODULE AND ELECTRONIC DEVICE", and claims priority to patent application for invention with the application No. 202410781766.1 filed on 17 June 2024 and titled "CHIP ENCAPSULATION STRUCTURE AND ELECTRONIC DEVICE", the entire contents of which are incorporated herein by reference.

### TECHNICAL FIELD

The present disclosure relates to the technical field of an electrical element, and specifically relates to an optical sensing module and an electronic device.

### BACKGROUND

An increasingly thin, full-screen, and narrow-framed electronic product such as a mobile phone has become a mainstream direction of development of electronic products at present. In an environment of this mainstream design, space left for an optical sensing module becomes increasingly small, so that the demand for a system integration product of an under-display environmental optical sensing module and an optical proximity sensing module becomes increasingly urgent.

However, increasing integration level of the product will further cause signal interference problems between subsystems. For example, coupling of an electrical signal from a screen module with the optical sensing module will generate an interference signal.

With the development of high-end consumer electronic products and optical sensors, the demand for the integration of optical sensor systems installed under a mobile phone screen becomes increasingly strong, and the demand for the accuracy of optical signal recognition becomes increasingly high.

Thus it can be seen that an existing integration solution of a transparent encapsulation system of optical sensors has the problems of electrical noise interference between subsystems and optical interference of light reflection inside fully transparent encapsulation. Electrical noise interference causes a high work noise of a device, deteriorates signal-to-noise ratio (SNR) performance of the device, and affects the accuracy of optical signal recognition. Optical interference causes distortion of real optical signal data and reduces the accuracy of optical signal recognition.

### SUMMARY

In view of this, the present disclosure provides an optical sensing module and an electronic device, to solve the technical problem that coupling of an electrical signal from a screen module with an optical sensing module of a conventional solution will generate an interference signal.

A first aspect of the present disclosure provides an optical sensing module, comprising: a substrate, a light shielding layer, one or more optical sensing chips, a light-transmitting layer, and a transparent conducting layer; wherein the one or more optical sensing chips are arranged above the substrate; the light shielding layer clads a portion of the one or more optical sensing chips without contacting the substrate and the light-transmitting layer, and clads a portion of the light-transmitting layer that excludes the second surface of the light-transmitting layer and an area not in contact with the one or more optical sensing chips, wherein a first surface of the light-transmitting layer is opposite to the second surface of the light-transmitting layer; the transparent conducting layer is in contact with the second surface of the light-transmitting layer, and is electrically connected to a ground wire in the substrate; the transparent conducting layer is configured to shield an interference signal from the one or more optical sensing chips; and the one or more optical sensing chips are configured to generate a corresponding electrical signal based on an optical signal transmitting through the transparent conducting layer and the light-transmitting layer and reaching a sensing region.

A second aspect of the present disclosure provides an electronic device, comprising: an optical sensing module and a screen module according to any one embodiment in the above first aspect.

Regarding the optical sensing module provided in the present disclosure, a transparent conducting layer is provided in the optical sensing module, and when the optical sensing module is integrated with other modules, an interference signal can be shielded by the transparent conducting layer, to avoid signal interference between the optical sensing module and the other modules, thereby improving the accuracy of the electrical signal generated by the optical sensing module.

### BRIEF DESCRIPTION OF DRAWINGS

To more clearly describe technical solutions in embodiments of the present disclosure or the prior art, drawings to be used in the description of the embodiments or the prior art will be briefly introduced below. Apparently, the drawings in the description below are merely some embodiments disclosed in the embodiments of the present disclosure. For those of ordinary skills in the art, other drawings may also be obtained based on these drawings.
FIG. 1 is a structural section view of an optical sensing module in an embodiment of the present disclosure;
FIG. 2 is a structural section view of an optical sensing module in another embodiment of the present disclosure;
FIG. 3 is a schematic structural diagram of an optical sensing module in an embodiment of the present disclosure;
FIG. 4 is a structural section view of an optical sensing module in still another embodiment of the present disclosure;
FIG. 5 is a schematic structural diagram of an optical sensing module in another embodiment of the present disclosure;
FIG. 6 is a structural section view of an optical sensing module in yet another embodiment of the present disclosure;
FIG. 7 is a structural section view of an optical sensing module comprising a die attach film in an embodiment of the present disclosure;
FIG. 8 is a structural section view of an optical sensing module comprising a bonding layer in an embodiment of the present disclosure;
FIG. 9 is a schematic diagram of an electronic device in an embodiment of the present disclosure;
FIG. 10 is a longitudinal section view of an optical sensing module in a first embodiment of the present disclosure;
FIG. 11 is a longitudinal section view of an optical sensing module in a second embodiment of the present disclosure;
FIG. 12 is a longitudinal section view of an optical sensing module in a third embodiment of the present disclosure;
FIG. 13 is a longitudinal section view of an optical sensing module in a fourth embodiment of the present disclosure;
FIG. 14 is a longitudinal section view of an optical sensing module in a fifth embodiment of the present disclosure;
FIG. 15 is a longitudinal section view of an optical sensing module in a sixth embodiment of the present disclosure;
FIG. 16 is a longitudinal section view of an optical sensing module in a seventh embodiment of the present disclosure; and
FIG. 17 is a longitudinal section view of an optical sensing module in an eighth embodiment of the present disclosure.

### List of reference numerals:

| | | | | | |
|---|---|---|---|---|---|
| 100: | Optical sensing module | 101: | Substrate | 102: | Light shielding layer |
| 103: | Optical sensing chip | 104: | Light-transmitting layer | 105: | Transparent conducting layer |
| 106: | First welding wire | 107: | Conductor | 108: | Die attach film |
| 109: | Bonding layer | 110: | Processing chip | 111: | Second welding wire |
| 1011: | Ground wire | 1012: | First wiring terminal | 1013: | Second wiring terminal |
| 1031: | First optical sensing chip | 1032: | Second optical sensing chip | 1051: | Transparent conductive segment |
| 202: | Metal ball | 204: | Welding wire | 208: | First redistribution layer |
| 209: | Second redistribution layer | 2010: | Conductive member | 300: | Electronic device |
| 301: | Screen module | | | | |

### DETAILED DESCRIPTION

To enable those skilled in the art to better understand technical solutions of embodiments of the present disclosure, the technical solutions of the embodiments of the present disclosure will be clearly and completely described below with reference to the drawings in the embodiments of the present disclosure. Apparently, the described embodiments are merely some, instead of all, of the embodiments of the present disclosure. All other embodiments obtained by those of ordinary skills in the art based on some embodiments among the embodiments of the present disclosure should be encompassed within the scope of protection of the embodiments of the present disclosure.

The terms used in the present disclosure are intended merely to describe particular embodiments, and are not intended to limit the present disclosure. The singular forms of "a" and "the" used in the present disclosure and the appended claims are also intended to include plural forms, unless the context explicitly indicates other meanings. It should be further understood that the term "and/or" used herein refers to and includes any or all possible combinations of one or more associated enumerated items.

It should be understood that various kinds of information may be described by using the terms, such as first, second, and third, in the present disclosure, but the information should not be limited to these terms. These terms are merely used to distinguish between information of a same type. For example, the first piece of information may also be called the second piece of information, and similarly, the second piece of information may also be called the first piece of information, without departing from the scope of the present disclosure. Depending on the context, as used herein, the word "if" may be interpreted as "at the time of..." or "when..." or "in response to determining".

An embodiment of the present disclosure provides an optical sensing module, comprising: a substrate, a light shielding layer, one or more optical sensing chips, a light-transmitting layer, and a transparent conducting layer.

The one or more optical sensing chips are arranged above the substrate, the light-transmitting layer is arranged above the one or more optical sensing chips, the light shielding layer clads a portion of the one or more optical sensing chips without contacting the substrate and the light-transmitting layer, the transparent conducting layer is arranged above the light-transmitting layer or/and the transparent conducting layer is arranged above the one or more optical sensing chips, and the transparent conducting layer is electrically connected to a ground wire in the substrate.

The transparent conducting layer is configured to shield an interference signal from the one or more optical sensing chips. The one or more optical sensing chips are configured to generate a corresponding electrical signal based on an optical signal transmitting through the transparent conducting layer and the light-transmitting layer and reaching a sensing region.

The one or more optical sensing chips may be integrated in the optical sensing module, and one or more different optical sensing chips can implement same or different sensing functions. For example, the one or more optical sensing chips may include at least one of an ambient light sensor, a proximity sensor, a color temperature sensor, an image sensor, or a light emitting chip. Light can pass through the transparent conducting layer and the light-transmitting layer of the optical sensing module sequentially to reach the one or more optical sensing chips, for sensing by the one or more optical sensing chips.

In an embodiment of the present disclosure, a transparent conducting layer is provided in the optical sensing module, and when the optical sensing module is integrated with other modules, an interference signal can be shielded by the transparent conducting layer, to avoid signal interference between the optical sensing module and the other modules, thereby improving the accuracy of the electrical signal generated by the optical sensing module.

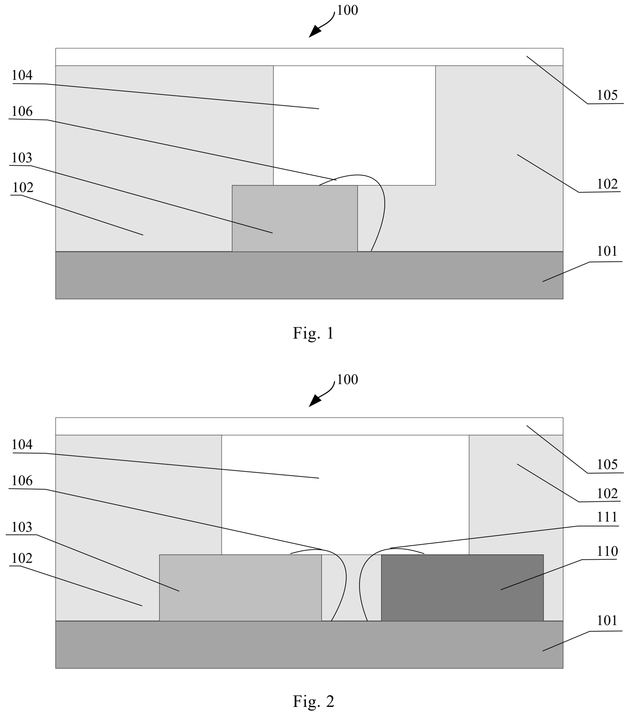

FIG. 1 is a structural section view of an optical sensing module in an embodiment of the present disclosure. As shown in FIG. 1, the optical sensing module 100 comprises: a substrate 101, a light shielding layer 102, one or more optical sensing chips 103, a light-transmitting layer 104, and a transparent conducting layer 105.

A first surface of the one or more optical sensing chips 103 is in contact with a first surface of the substrate 101, and the one or more optical sensing chips 103 are electrically connected to the substrate 101 through a first welding wire 106, wherein the first surface of the one or more optical sensing chips 103 is opposite to a second surface of the one or more optical sensor chips. A sensing region located on the second surface of the one or more optical sensing chips 103 is in contact with a first surface of the light-transmitting layer 104. The light shielding layer 102 clads a portion of the one or more optical sensing chips 103 without contacting the substrate 101 and the light-transmitting layer 104, and the light shielding layer 102 clads a portion of the light-transmitting layer 104 that excludes the second surface of the light shielding layer 102 and an area not in contact with the one or more optical sensing chips 103, wherein the first surface of the light-transmitting layer 104 is opposite to the second surface of the light-transmitting layer. The transparent conducting layer 105 is in contact with the light shielding layer 102 and the second surface of the light-transmitting layer 104, and the transparent conducting layer 105 is electrically connected to a ground wire in the substrate 101.

The transparent conducting layer 105 is configured to shield an interference signal from the one or more optical sensing chips 103. The one or more optical sensing chips 103 are configured to generate a corresponding electrical signal based on an optical signal transmitting through the transparent conducting layer 105 and the light-transmitting layer 104 and reaching the sensing region.

Flow over wire (FOW) technology is used for the one or more optical sensing chips 103, to electrically connect to the substrate 101 through the first welding wire 106. For example, one end of the first welding wire 106 can be electrically connected to a welding terminal on the one or more optical sensing chips 103, and the other end of the first welding wire 106 can be electrically connected to a wiring terminal on the first surface of the substrate 101 to electrically connect the one or more optical sensing chips 103 to the substrate 101. The substrate 101 may be a printed circuit board for encapsulation. There is a circuit in the substrate 101. The one or more optical sensing chips 103 lead an electrical signal generated when sensing an optical signal to the substrate 101 through the first welding wire 106, and the substrate 101 is then interconnected with an external signal through, e.g., the wiring terminal or a solder ball.

It should be noted that in an embodiment of the present disclosure, the sensing region located on the second surface of the one or more optical sensing chips 103 is in contact with the first surface of the light-transmitting layer 104, but a portion of the second surface of the one or more optical sensing chips 103 in contact with the first surface of the light-transmitting layer 104 is not only limited to the sensing region on the second surface of the one or more optical sensing chips 103. Since there may be one or more light sources in a usage scenario of the optical sensing module 100, in order to prevent excessive optical signals other than an optical signal required to reach the one or more optical sensing chips 103 from transmitting through the light-transmitting layer 104 to reach the one or more optical sensing chips 103, the first surface of the light-transmitting layer 104 cannot be set to have a too large area. Therefore, when the optical sensing module 100 comprises a plurality of the one or more optical sensing chips 103, the second surfaces of the plurality of the one or more optical sensing chips 103 may not all be in contact with the first surface of the light-transmitting layer 104 because of being limited to the area of the first surface of the light-transmitting layer 104. Therefore, it is only necessary to satisfy the requirement that the sensing regions on the second surfaces of the plurality of the one or more optical sensing chips 103 are in contact with the first surface of the light-transmitting layer 104. However, if a small number of the one or more optical sensing chips 103, or only one or more optical sensing chips 103 are included in the optical sensing module 100, and the second surface of the one or more optical sensing chips 103 has a small area, the second surface of the one or more optical sensing chips 103 can be completely in contact with the first surface of the light-transmitting layer 104.

In order to solve the signal interference problem caused by increasing integration level of the optical sensing module 100 and other modules, such as a screen module, a transparent conducting layer 105 is provided in the optical sensing module 100. The transparent conducting layer 105 may be composed of a material such as an organic or inorganic conductive coating or a printed material, e.g., silver tin oxide. For example, in a scenario where coupling of the optical sensing module 100 with the screen module generates an interference signal, at a moment, the screen module generates an electrical signal, and the optical sensing module 100 also generates a corresponding electrical signal based on the optical signal transmitting through the transparent conducting layer 105 and the light-transmitting layer 104 and reaching the sensing region. Due to high integration level of the optical sensing module 100 with the screen module, the optical sensing module 100 is coupled with the screen module, and both the electrical signal generated by the optical sensing module 100 and the electrical signal generated by the screen module may be affected, thereby reducing the accuracy of the electrical signals. In this case, the transparent conducting layer 105 is provided in the optical sensing module 100, the transparent conducting layer 105 is arranged between the optical sensing module 100 and the screen module, and the transparent conducting layer 105 is electrically connected to the ground wire in the substrate 101. Therefore, the transparent conducting layer 105 will introduce an interference signal caused by the screen module to the optical sensing module 100 when generating the electrical signal into the ground wire in the substrate 101, and flows the interference signal out. Moreover, the transparent conducting layer 105 will also introduce an interference signal caused by the optical sensing module 100 to the screen module when generating the electrical signal into the ground wire in the substrate 101.

In an embodiment of the present disclosure, a transparent conducting layer 105 is provided in the optical sensing module 100, and when the optical sensing module 100 is integrated with other modules, the interference signals can be shielded by the transparent conducting layer 105, to avoid signal interference between the optical sensing module 100 and the other modules, thereby improving the accuracy of the electrical signal generated by the optical sensing module 100.

FIG. 2 is a structural section view of an optical sensing module in another embodiment of the present disclosure. As shown in FIG. 2, the optical sensing module 100 further comprises: a processing chip 110, a first surface of the processing chip 110 is in contact with the first surface of the substrate 101, and the light shielding layer 102 clads a portion of the processing chip 110 without contacting the substrate 101 and the light-transmitting layer 104. The processing chip 110 is electrically connected to the substrate 101 through a second welding wire 111.

In an embodiment of the present disclosure, by additionally providing the processing chip 110 in the optical sensing module 100, a chip, such as a control chip, a light intensity sensing chip, or a color temperature sensing chip, can be selected based on different scenarios to satisfy different requirements, thereby improving the adaptability of the optical sensing module 100.

In a possible implementation, the light shielding layer 102 is an opaque black EMC (Epoxy Molding Compound).

In some scenarios, the optical signal can transmit through the light shielding layer 102. When the optical signal transmits through the light shielding layer 102 to reach the sensing region on the second surface of the one or more optical sensing chips 103, the one or more optical sensing chips 103 may generate an electrical signal by incorrect sensing. In order to avoid this situation, the light shielding layer 102 can be formed by using epoxy resin as the matrix and adding an Epoxy Molding Compound (EMC) obtained by mixing a variety of adjuvants including a black dye and a material that increases the structural strength. When the light shielding layer 102 is opaque black, the optical signal can only transmit through the transparent conducting layer 105 and the light-transmitting layer 104 to reach the sensing region of the one or more optical sensing chips 103.

In an embodiment of the present disclosure, setting the light shielding layer 102 to opaque black can prevent unnecessary optical signals from transmitting through the light shielding layer 102 to reach the sensing region on the second surface of the one or more optical sensing chips 103, thereby ensuring the accuracy of a corresponding electrical signal generated by the one or more optical sensing chips 103 based on the optical signal. Moreover, the epoxy molding compound comprises the material that increases the structural strength, thereby reducing the deformation effects such as warping caused by stress, or the influence of heat generation of the one or more optical sensing chips 103 on the structure of the light shielding layer 102, and improving the structural strength of the optical sensing module 100.

In a possible implementation, a surface of the light shielding layer 102 in contact with the transparent conducting layer 105 is flush with the second surface of the light-transmitting layer 104.

When the surface of the light shielding layer 102 in contact with the transparent conducting layer 105 is not flush with the second surface of the light-transmitting layer 104, a surface of the transparent conducting layer 105 in contact with both the light shielding layer 102 and the light-transmitting layer 104 will present a "convex" shape or a "concave" shape, which will bring difficulty in assembly when the optical sensing module 100 is integrated with the other modules. Therefore, the surface of the light shielding layer 102 in contact with the transparent conducting layer 105 is flush with the second surface of the light-transmitting layer 104, so that the surface of the transparent conducting layer 105 in contact with both the light shielding layer 102 and the light-transmitting layer 104 can be flat.

In an embodiment of the present disclosure, the surface of the light shielding layer 102 in contact with the transparent conducting layer 105 is set to be flush with the second surface of the light-transmitting layer 104, so that the surface of the transparent conducting layer 105 in contact with both the light shielding layer 102 and the light-transmitting layer 104 is flat, thereby contributing to the integration of the optical sensing module 100 with the other modules.

In one possible implementation, a light transmittance of the transparent conducting layer 105 is greater than 90%.

In an embodiment of the present disclosure, setting the light transmittance of the transparent conducting layer 105 to be greater than 90% can reduce the loss of the optical signal when transmitting through the transparent conducting layer 105, and when the light transmittance of the transparent conducting layer 105 is only required to be greater than 90%, the manufacturing costs of the transparent conducting layer 105 will not be too high.

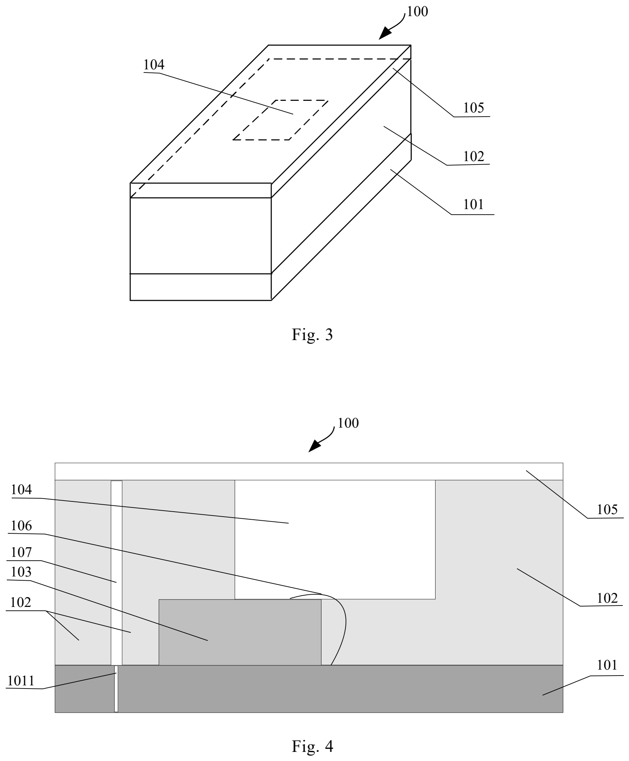

FIG. 3 is a schematic structural diagram of an optical sensing module in an embodiment of the present disclosure, and FIG. 4 is a structural section view of an optical sensing module in still another embodiment of the present disclosure. As shown in FIG. 4, in the optical sensing module 100, the transparent conducting layer 105 is electrically connected with a ground wire 1011 in the substrate 101 through a conductor 107, such as a circuit board, a third welding wire, or a conductive pillar.

In the optical sensing module 100 shown in FIGS. 3 and 4, the transparent conducting layer 105 is not in contact with a side surface of the substrate 101. Therefore, in order to enable the transparent conducting layer 105 to introduce the interference signal into the substrate 101, the circuit board, the third welding wire, or the conductive pillar extending through the light shielding layer 102 can be arranged, one terminal of the circuit board, the third welding wire, or the conductive pillar is connected to the transparent conducting layer 105, and the other terminal of the circuit board, the third welding wire, or the conductive pillar is electrically connected to the ground wire 1011 in the substrate 101. The circuit board may be a printed circuit board (PCB), and specifically may be, e.g., a single-sided circuit board, a double-sided circuit board, and a multilayer circuit board. The conductive pillar may be a copper pillar.

In an embodiment of the present disclosure, when the transparent conducting layer 105 is electrically connected to the ground wire 1011 in the substrate 101 through the third welding wire, the manufacturing costs of the optical sensing module 100 can be reduced due to low costs of the third welding wire. When the transparent conducting layer 105 is electrically connected to the ground wire 1011 in the substrate 101 through the conductive pillar, anti-interference ability of the transparent conducting layer 105 can be improved due to good conductivity of the conductive pillar. When the transparent conducting layer 105 is set to be electrically connected to the ground wire 1011 in the substrate 101 through the circuit board, the structural strength of the optical sensing module 100 can be further improved due to high structural strength of the circuit board.

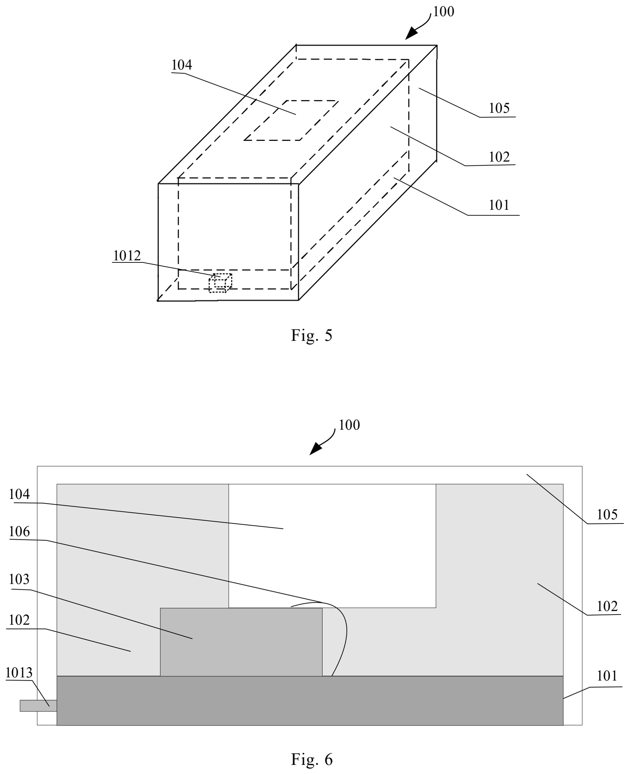

FIG. 5 is a schematic structural diagram of an optical sensing module in another embodiment of the present disclosure, and FIG. 6 is a structural section view of an optical sensing module in yet another embodiment of the present disclosure. As shown in FIGS. 5-6, in the optical sensing module 100, a side surface of the substrate 101 is in contact with the transparent conducting layer 105, and a surface of the light shielding layer 102 without contacting the one or more optical sensing chips 103, the light-transmitting layer 104, or the substrate 101 is in contact with the transparent conducting layer 105, wherein the first surface of the substrate 101 is opposite to the second surface of the substrate, and the side surface of the substrate 101 is perpendicular to the first surface and the second surface of the substrate 101.

In the optical sensing module 100, the transparent conducting layer 105 is in contact with the side surface of the substrate 101, for example, there may be several first wiring terminals 1012 on the side surface of the substrate 101, so that the transparent conducting layer 105 is directly electrically connected to the substrate 101.

In an embodiment of the present disclosure, by setting the side surface of the substrate 101 to be in contact with the transparent conducting layer 105, a portion of the light shielding layer 102 without contacting the one or more optical sensing chips 103 or the light-transmitting layer 104 or the substrate 101 is in contact with the transparent conducting layer 105, thereby expanding the area cladded by the transparent conducting layer 105, and further improving the anti-interference ability of the optical sensing module 100.

As shown in FIG. 6, the transparent conducting layer 105 is provided with a through hole for a second wiring terminal 1013 located on the side surface of the substrate 101 to run through.

Several second wiring terminals 1013 are provided on the side surface of the substrate 101, the second wiring terminals 1013 may be copper pillars, and the substrate 101 may communicate with the outside through the second wiring terminals 1013 extending through the transparent conducting layer 105.

In an embodiment of the present disclosure, the transparent conducting layer 105 is provided with a through hole for the second wiring terminal 1013 to run through, so that the substrate 101 can communicate with the outside.

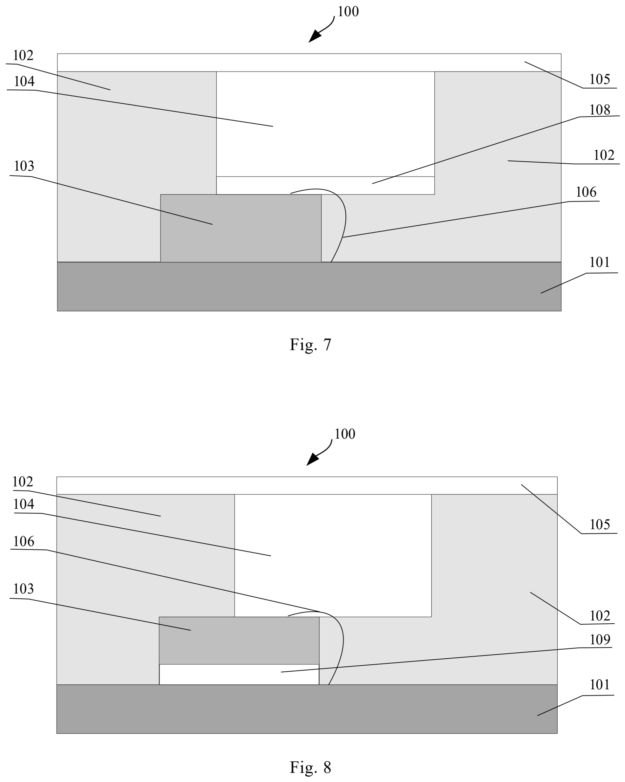

FIG. 7 is a schematic structural diagram of an optical sensing module comprising a die attach film in an embodiment of the present disclosure. As shown in FIG. 7, in the optical sensing module 100, the first surface of the light-transmitting layer 104 is in contact with the sensing region through the die attach film 108. A light transmittance of the die attach film 108 is greater than or equal to a light transmittance of the light-transmitting layer 104.

The die attach film 108 (DAF) may be an adhesive film that is made of epoxy resin, has a high light transmittance, and has adhesiveness at room temperature or a high temperature. When the light-transmitting layer 104 is in contact with the one or more optical sensing chips 103, the die attach film 108 is applied or sprayed between the light-transmitting layer 104 and the one or more optical sensing chips 103, and the die attach film 108 is subjected to a chemical reaction by baking the die attach film 108 for curing.

In an embodiment of the present disclosure, the light-transmitting layer 104 is in contact with the sensing region on the second surface of the one or more optical sensing chips 103 through the die attach film 108, which can improve the bonding strength and avoid falling off. In addition, since the light transmittance of the die attach film 108 is greater than or equal to the light transmittance of the light-transmitting layer 104, the die attach film 108 will not affect the optical signal reaching the sensing region on the second surface of the one or more optical sensing chips 103.

In a possible implementation, the first welding wire 106 comprises a first portion and a second portion that are electrically connected. The first portion of the first welding wire 106 is connected to a wiring terminal located on the second surface of the one or more optical sensing chips 103 and runs through the inside of the die attach film 108. The second portion of the first welding wire 106 runs through the light shielding layer 102, and is connected to the wiring terminal on the substrate 101.

In an embodiment of the present disclosure, by setting the first welding wire 106 to run through the inside of the die attach film 108 and then through the light shielding layer 102, the first welding wire 106 can be fixed through the die attach film 108 and the light shielding layer 102 respectively, thereby improving the safety of the optical sensing module 100.

FIG. 8 is a schematic structural diagram of an optical sensing module comprising a second die attach film or a silver glue in the present disclosure. As shown in FIG. 8, in the optical sensing module 100, the first surface of the one or more optical sensing chips 103 is in contact with the first surface of the substrate 101 through a bonding layer 109, such as the second die attach film or the silver glue, and the second die attach film and the silver glue are not conductive.

The second die attach film (DAF) may be an adhesive film made of epoxy resin and has viscosity at normal temperature or a high temperature. The silver glue may be a viscous colloid formed by bonding a silver material through bonding effect of a matrix resin.

In an embodiment of the present disclosure, the one or more optical sensing chips 103 are in contact with the first surface of the substrate 101 through the non-conductive second die attach film or silver glue, which can improve the bonding strength and avoid falling off.

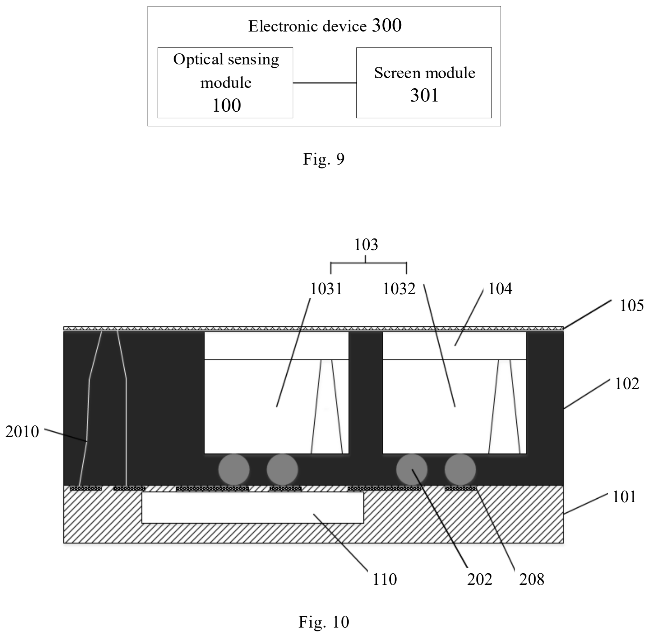

FIG. 9 is a schematic diagram of an electronic device in an embodiment of the present disclosure. As shown in FIG. 9, the electronic device 300 comprises the optical sensing module 100 and the screen module 301 according to any one of the above embodiments.

It should be noted that the electronic device 300 in an embodiment of the present disclosure is a specific application of the optical sensing module 100 in the above embodiments in various electronic products (such as a smart phone and a tablet computer). The description in the above embodiments of the optical sensing module may be referred to for the optical sensing module 100 in the specific electronic device, which will not be repeated here.

In an embodiment of the present disclosure, a transparent conducting layer is provided in the optical sensing module 100, and when the optical sensing module 100 is integrated with the screen module 301, an interference signal generated during coupling of the screen module 301 with the optical sensing module 100 can be shielded by the transparent conducting layer, to avoid signal interference between the optical sensing module 100 and the screen module 301, thereby improving the accuracy of the electrical signal generated by the optical sensing module 100 and the screen module 301.

This embodiment specifically discloses an optical sensing module, as shown in FIG. 10-17, comprising a substrate 101, one or more optical sensing chips 103, a processing chip 110, and a light shielding layer 102. The substrate 101 in this embodiment is provided with a circuit, which serves as a carrier for encapsulation to realize interconnection with an external signal. In this embodiment, the substrate 101 is a PCB substrate.

The one or more optical sensing chips 103 are mounted on the substrate 101 in a flipping manner or/and the processing chip 110, and the one or more optical sensing chips 103 are electrically connected to the substrate 101 or/and the processing chip 110 thereunder.

When the number of optical sensing chips 103 is one, the one optical sensing chip 103 may be mounted on the substrate 101 in the flipping manner, or may be mounted on the processing chip 110 in the flipping manner; while when the number of optical sensing chips 103 is a plural number, some of the optical sensing chips 103 may be mounted on the substrate 101 in the flipping manner, and other optical sensing chips 103 may be mounted on the processing chip 110 in the flipping manner, or all of the optical sensing chips 103 may be mounted on the substrate 101 in the flipping manner, or all of the optical sensing chips 103 may be mounted on the processing chip 110 in the flipping manner.

The one or more optical sensing chips 103 are provided with a second through silicon via, which is electrically connected to the processing chip 110 or/and the substrate 101, to electrically connect the one or more optical sensing chips 103 to the substrate 101 or/and the processing chip 110. The one or more optical sensing chips 103 are devices for transmitting an optical signal with the outside world. The one or more optical sensing chips 103 comprise at least one of an ambient light sensor, a proximity sensor, a color temperature sensor, an image sensor, or a light emitting chip. The number and types of the optical sensing chips 201 are set based on requirements.

As an optional embodiment, as shown in FIGS. 10-17, the optical sensing chips 103 comprise a first optical sensing chip 1031 and a second optical sensing chip 1032, the first optical sensing chip 1031 and the second optical sensing chip 1032 comprise an ambient light sensor and a proximity sensor, and relative positions of the first optical sensing chip 1031 and the second optical sensing chip 1032 are not particularly limited and can be set based on requirements.

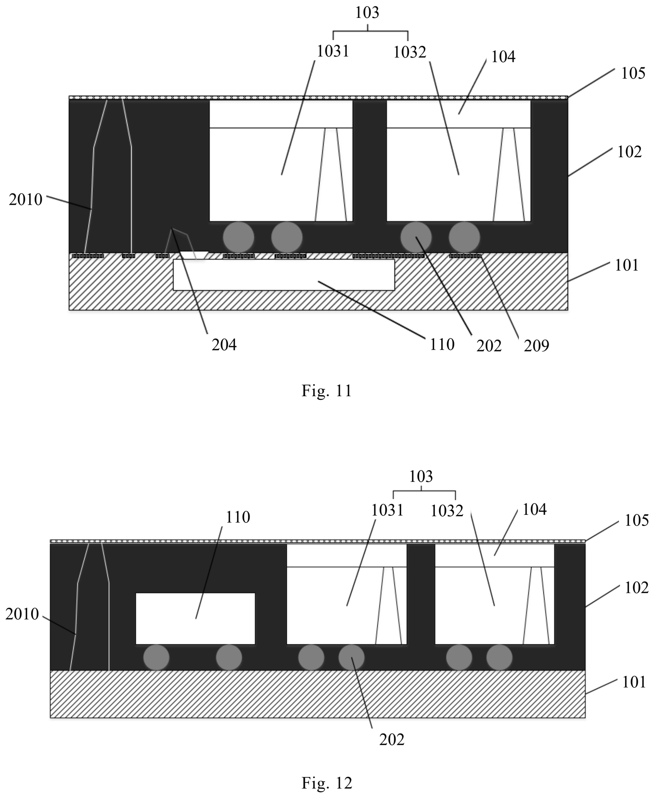

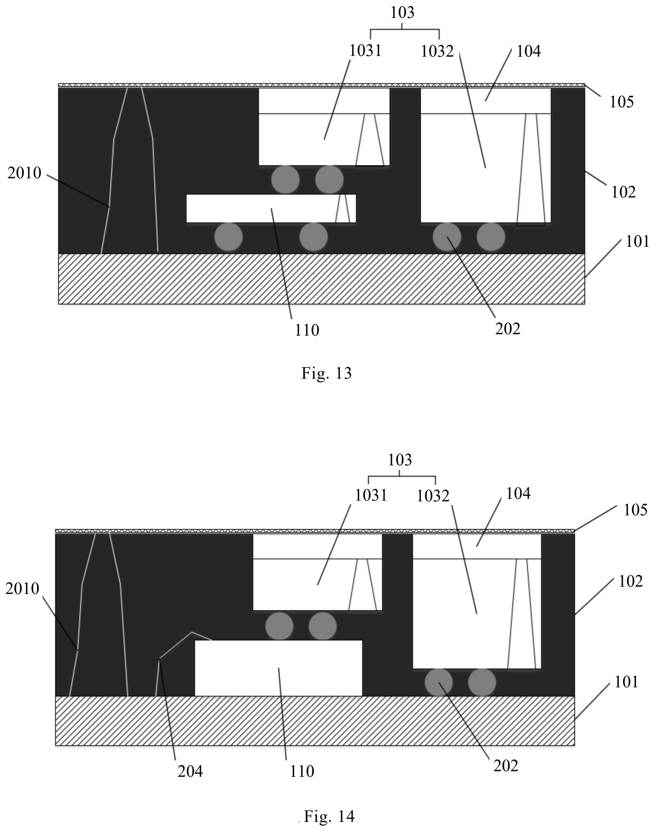

The processing chip 110 is embedded in the substrate 101 (as shown in FIGS. 10, 11, 15, 16, and 17), mounted above the substrate 101 in the flipping manner (as shown in FIGS. 12 and 13), or fixed above the substrate 101 (as shown in FIG. 14), and the processing chip 110 is electrically connected to the substrate 101. The processing chip 110 comprises at least one of an analog front end chip, a control chip, or a signal processing chip. Type of the processing chip 110 is selected based on actual requirements.

Optionally, as shown in FIGS. 10, 15, 16, and 17, when the processing chip 110 is embedded in the substrate 101, a first redistribution layer 208 is provided on a top layer of the substrate 101, and the first redistribution layer 208 is arranged above the processing chip 110, and the first redistribution layer 208 is electrically connected to a bonding pad of the processing chip 110. The first redistribution layer 208 distributes electrical signal connection points on a surface of the substrate 101, and the first redistribution layer 208 is electrically connected to the entire bonding pad of the processing chip 110 to interconnect the substrate 101 to the processing chip 110. The first optical sensing chip 1031 and the second optical sensing chip 1032 are mounted above the substrate 101 in the flipping manner, the first redistribution layer 208 is welded to a metal ball 202 thereabove, and the metal ball 202 is welded to the first optical sensing chip 1031 and the second optical sensing chip 1032 that are mounted in the flipping manner, to electrically connect the processing chip 110 and the substrate 101 to the first optical sensing chip 1031 and the second optical sensing chip 1032, and complete the system integration.

Optionally, the first optical sensing chip 1031 and the second optical sensing chip 1032 are each provided with a second through silicon via, which is electrically connected to the processing chip 110 and the substrate 101. The second through silicon via on the first optical sensing chip 1031 leads an electrical signal from a bonding pad of the first optical sensing chip 1031 to below the first optical sensing chip 1031. A lower surface of the first optical sensing chip 1031 is provided with a third redistribution layer, which is electrically connected to the second through silicon via. The third redistribution layer on the lower surface of the first optical sensing chip 1031 is welded to the first redistribution layer 208 through the metal ball 202. A second through silicon via on the second optical sensing chip 1032 leads an electrical signal from a bonding pad of the second optical sensing chip 1032 to below the second optical sensing chip 1032. A lower surface of the second optical sensing chip 1032 is provided with a third redistribution layer, which is electrically connected to the second through silicon via. The third redistribution layer on the lower surface of the second optical sensing chip 1032 is welded to the first redistribution layer 208 through the metal ball 202. The third redistribution layer comprises a redistribution wire and a redistribution bonding pad, the redistribution wire is connected to the second through silicon via and the redistribution bonding pad respectively, and the redistribution bonding pad is welded to the first redistribution layer 208 through the metal ball 202.

In this embodiment, the metal ball 202 may be a solder ball. The one or more optical sensing chips 103 adopt a TSV (Through Silicon Via) encapsulation process, and an electrical signal from a bonding pad on a surface of the one or more optical sensing chips 103 is led to a metal ball 202 on back of the one or more optical sensing chips 103 through the through silicon via and a metal redistribution technology, thereby omitting the welding wire for electrically connecting the one or more optical sensing chips 103 to the processing chip 110 and the substrate 101.

In the embodiments shown in FIGS. 10, 15, 16, and 17, the welding wire is completely omitted, thereby still further reducing the electrical noise interference between the welding wire and the screen, and improving the accuracy of optical signal recognition.

Optionally, as shown in FIG. 11, when the processing chip 110 is embedded in the substrate 101, the top layer of the substrate 101 is provided with a second redistribution layer 209, the second redistribution layer 209 is arranged above the processing chip 110, the second redistribution layer 209 is electrically connected to a portion of the bonding pad of the processing chip 110, and other portion of the bonding pad of the processing chip 110 is electrically connected to the substrate 101 through a welding wire 204.

Specifically, one end of the welding wire 204 is connected to the other portion of the bonding pad of the processing chip 110, and the other end of the welding wire 204 is connected to the second redistribution layer 209. The second redistribution layer 209 distributes electrical signal connection points on a surface of the substrate 101. The second redistribution layer 209 is electrically connected to a portion of the bonding pad of the processing chip 110. After the processing chip 110 is embedded in the substrate 101, a portion of the bonding pad of the processing chip 110 is exposed. The exposed bonding pad of the processing chip 110 is connected to the second redistribution layer 209 through the welding wire 204. Specifically, one end of the welding wire 204 is connected to the exposed bonding pad of the processing chip 110, and the other end of the welding wire 204 is connected to the second redistribution layer 209. The substrate 101 is interconnected to the processing chip 110 through the second redistribution layer 209 and the welding wire 204; the first optical sensing chip 1031 and the second optical sensing chip 1032 are mounted above the substrate 101 in the flipping manner, the second redistribution layer 209 is welded to the metal ball 202 thereabove, and the metal ball 202 is welded to the first optical sensing chip 1031 and the second optical sensing chip 1032 that are mounted in the flipping manner, to electrically connect the processing chip 110 and the substrate 101 to the first optical sensing chip 1031 and the second optical sensing chip 1032, and complete the system integration.

Optionally, the first optical sensing chip 1031 and the second optical sensing chip 1032 are each provided with a second through silicon via, which is electrically connected to the processing chip 110 and the substrate 101. The lower surface of the first optical sensing chip 1031 is provided with the third redistribution layer, which is electrically connected to the second through silicon via. The third redistribution layer on the lower surface of the first optical sensing chip 1031 is welded to the second redistribution layer 209 through the metal ball 202. The lower surface of the second optical sensing chip 1032 is provided with the third redistribution layer, which is electrically connected to the second through silicon via. The third redistribution layer on the lower surface of the second optical sensing chip 1032 is welded to the second redistribution layer 209 through the metal ball 202. The one or more optical sensing chips 103 adopt the TSV encapsulation process, and the electrical signal from the bonding pad on the surface of the one or more optical sensing chips 103 is led to the metal ball 202 on the back of the one or more optical sensing chips 103 through the through silicon via and the metal redistribution technology, thereby omitting the welding wire for electrically connecting the one or more optical sensing chips 103 to the processing chip 110 and the substrate 101.

Compared with the prior art, the embodiment shown in FIG. 11 still greatly reduces the number of welding wires, further reduces the electrical noise interference between the welding wires and the screen, and improves the accuracy of optical signal recognition.

Optionally, as shown in FIGS. 12 and 13, when the processing chip 110 is mounted above the substrate 101 in the flipping manner, the processing chip 110 is provided with a first through silicon via, which is electrically connected to the substrate 101. Specifically, a fourth redistribution layer is provided on a lower surface of the processing chip 110, the fourth redistribution layer is electrically connected to the first through silicon via, and the fourth redistribution layer is welded to the substrate 101 through the metal ball 202. The first through silicon via provided on the processing chip 110 leads the electrical signal from the bonding pad of the processing chip 110 to below of the processing chip 110, and the fourth redistribution layer on the lower surface of the processing chip 110 comprises a redistribution wire and a redistribution bonding pad, the redistribution wire is connected to the first through silicon via and the redistribution bonding pad respectively, and the redistribution bonding pad is welded to the substrate 101 through the metal ball 202. The processing chip 110 adopts the TSV encapsulation process, and the electrical signal from the bonding pad on the surface of the processing chip 110 is led to the metal ball 202 on the back of the processing chip 110 through the through silicon via and the metal redistribution technology, thereby omitting the welding wire for electrically connecting the processing chip 110 to the substrate 101, and reducing the electrical noise interference between the welding wire and the screen.

When the processing chip 110 is mounted above the substrate 101 in the flipping manner, the one or more optical sensing chips 103 are mounted on the processing chip 110 or/and the substrate 101 in the flipping manner.

Optionally, in the embodiment shown in FIG. 12, the first optical sensing chip 1031 and the second optical sensing chip 1032 are each mounted above the substrate 101 in the flipping manner, and the first optical sensing chip 1031 and the second optical sensing chip 1032 are electrically connected to the substrate 101. The first optical sensing chip 1031 and the second optical sensing chip 1032 are each provided with a second through silicon via, which is electrically connected to the substrate 101. The lower surface of the first optical sensing chip 1031 is provided with the third redistribution layer, which is electrically connected to the second through silicon via. The third redistribution layer on the lower surface of the first optical sensing chip 1031 is welded to the substrate 101 through the metal ball 202. The lower surface of the second optical sensing chip 1032 is provided with the third redistribution layer, which is electrically connected to the second through silicon via. The third redistribution layer on the lower surface of the second optical sensing chip 1032 is welded to the substrate 101 through the metal ball 202. The one or more optical sensing chips 103 also adopt the TSV encapsulation process, and the electrical signal from the bonding pad on the surface of the one or more optical sensing chips 103 is led to the metal ball 202 on the back of the one or more optical sensing chips 103 through the through silicon via and the metal redistribution technology, thereby omitting the welding wire for electrically connecting the one or more optical sensing chips 103 to the substrate 101 by the electrical connection to the substrate 101 through the metal ball 202.

Optionally, in the embodiment shown in FIG. 13, the first optical sensing chip 1031 is mounted on the processing chip 110 in the flipping manner, and the second optical sensing chip 1032 is mounted on the substrate 101 in the flipping manner. The first optical sensing chip 1031 is provided with a second through silicon via, which is electrically connected to the processing chip 110. The second optical sensing chip 1032 is provided with a second through silicon via, which is electrically connected to the substrate 101. The lower surface of the first optical sensing chip 1031 is provided with the third redistribution layer, which is electrically connected to the second through silicon via. The third redistribution layer on the lower surface of the first optical sensing chip 1031 is welded to the processing chip 110 through the metal ball 202. The lower surface of the second optical sensing chip 1032 is provided with the third redistribution layer, which is electrically connected to the second through silicon via. The third redistribution layer on the lower surface of the second optical sensing chip 1032 is welded to the substrate 101 through the metal ball 202. The one or more optical sensing chips 103 adopt the TSV encapsulation process, and the electrical signal from the bonding pad on the surface of the one or more optical sensing chips 103 is led to the metal ball 202 on the back of the one or more optical sensing chips 103 through the through silicon via and the metal redistribution technology, thereby omitting the welding wire for electrically connecting the one or more optical sensing chips 103 to the processing chip 110 and the substrate 101 by the electrical connection to the processing chip 110 and the substrate 101 through the metal ball 202. In other embodiments, the first optical sensing chip 1031 and the second optical sensing chip 1032 may also each be mounted on the processing chip 110 in the flipping manner.

In the embodiments shown in FIGS. 12 and 13, the welding wire is completely omitted, thereby still further reducing the electrical noise interference between the welding wire and the screen, and improving the accuracy of optical signal recognition. Moreover, in the embodiment shown in FIG. 13, the first optical sensing chip 1031 is stacked vertically with the processing chip 110, to miniaturize the size of the integrated encapsulation in X and Y directions.

Optionally, as shown in FIG. 14, when the processing chip 110 is fixed above the substrate 101, the processing chip 110 is electrically connected to the substrate 101 through the welding wire 204. The one or more optical sensing chips 103 are mounted on the processing chip 110 or/and the substrate 101 in the flipping manner. The first optical sensing chip 1031 is mounted on the processing chip 110 in the flipping manner, and the second optical sensing chip 1032 is mounted on the substrate 101 in the flipping manner. The first optical sensing chip 1031 is provided with a second through silicon via, which is electrically connected to the processing chip 110. The second optical sensing chip 1032 is provided with a second silicon through via, which is electrically connected to the substrate 101. The lower surface of the first optical sensing chip 1031 is provided with the third redistribution layer, which is electrically connected to the second through silicon via. The third redistribution layer on the lower surface of the first optical sensing chip 1031 is welded to the processing chip 110 through the metal ball 202. The lower surface of the second optical sensing chip 1032 is provided with the third redistribution layer, which is electrically connected to the second through silicon via. The third redistribution layer on the lower surface of the second optical sensing chip 1032 is welded to the substrate 101 through the metal ball 202.

The one or more optical sensing chips 103 adopt the TSV encapsulation process, and the electrical signal from the bonding pad on the surface of the one or more optical sensing chips 103 is led to the metal ball 202 on the back of the one or more optical sensing chips 103 through the through silicon via and the metal redistribution technology, thereby omitting the welding wire for electrically connecting the one or more optical sensing chips 103 to the processing chip 110 and the substrate 101 by the electrical connection to the processing chip 110 and the substrate 101 through the metal ball 202. In this embodiment, only the welding wire 204 for interconnecting the processing chip 110 to the substrate 101 is provided, thereby, compared with the prior art, still greatly reducing the number of welding wires, further reducing the electrical noise interference between the welding wire and the screen, and improving the accuracy of optical signal recognition. Moreover, the one or more optical sensing chips 103 are stacked vertically with the processing chip 110, to miniaturize the size of the integrated encapsulation in the X and Y directions.

In some embodiments, as shown in FIGS. 10-17, the light shielding layer 102 is arranged above the substrate 101 and encapsulates the one or more optical sensing chips 103 and the processing chip 110, an opening is provided at a position, corresponding to the one or more optical sensing chips 103 on top of the light shielding layer 102, and the opening is configured to expose a photosensitive region of the one or more optical sensing chips 103 to transmit light. In the embodiments shown in FIGS. 12-17, an opening is provided above each of the first optical sensing chip 1031 and the second optical sensing chip 1032. The opening above the first optical sensing chip 1031 exposes the photosensitive region of the first optical sensing chip 1031, and the opening above the second optical sensing chip 1032 exposes the photosensitive region of the second optical sensing chip 1032. Preferably, the light shielding layer 102 is a black EMC (Epoxy Molding Compound) layer or a light-absorbing material layer. The light shielding layer 102 encapsulates all chips on the substrate 101. The light shielding layer 102 wraps side surfaces of the processing chip 110 and the one or more optical sensing chips 103, merely exposing the photosensitive region of the one or more optical sensing chips 103, thereby eliminating the problem of introducing optical signal interference caused by light reflection inside the transparent encapsulation, and improving the accuracy of optical signal recognition.

Optionally, a light-transmitting layer 104 is provided in the opening, and the light-transmitting layer 104 is fixed above the one or more optical sensing chips 103. As shown in FIGS. 10-17, a light-transmitting layer 104 is provided above each of the first optical sensing chip 1031 and the second optical sensing chip 1032. An upper surface of the light-transmitting layer 104 is flush with an upper surface of the light shielding layer 102. The light-transmitting layer 104 can further function to protect the one or more optical sensing chips 103. Preferably, the light-transmitting layer 104 is a transparent layer. More preferably, the light-transmitting layer 104 is a glass layer or a light-transmitting organic layer, and the light-transmitting organic layer is a light-transmitting organic resin layer.

When the light shielding layer 102 plastically encapsulates the processing chip 110 and the one or more optical sensing chips 103, the light-transmitting layer 104 or the photosensitive region portion corresponding to an upper surface of the one or more optical sensing chips 103 can be exposed through a grinding process; or the light-transmitting layer 104 or the photosensitive region portion corresponding to the upper surface of the one or more optical sensing chips 103 can be directly exposed through an open mold process.

In some embodiments, as shown in FIGS. 10-14 and 17, a transparent conducting layer 105 is provided on a top layer of the optical sensing module, and the transparent conducting layer 105 is electrically connected to the processing chip 110 or the substrate 101. When the light-transmitting layer 104 is not provided above the one or more optical sensing chips 103, the transparent conducting layer 105 is provided above the light shielding layer 102 and the one or more optical sensing chips 103; and when the light-transmitting layer 104 is provided above the one or more optical sensing chips 103, the transparent conducting layer 105 is provided above the light shielding layer 102 and the light-transmitting layer 104.

Optionally, the transparent conducting layer 105 comprises at least one of indium tin oxide, indium zinc oxide, a transparent conductive ink (mainly composed of conductive polymer PEDOT), nano silver, or a metal grid. The transparent conducting layer 105 is arranged on an upper surface of the entire optical sensing module through a process such as coating, printing, or spraying, and is grounded by interconnection to the processing chip 110 or the substrate 101, to achieve the electrical shielding function.

Optionally, the transparent conducting layer 105 is electrically connected to the processing chip 110 or the substrate 101 through a conductive member 2010 extending throughout the light shielding layer 102. The light shielding layer 102 exposes the top of the conductive member 2010 through the grinding process or the open mold process, the top of the conductive member 2010 is electrically connected to the transparent conducting layer 105, and the bottom of the conductive member 2010 is electrically connected to the processing chip 110 or the substrate 101 for grounding, to achieve the electrical shielding function. As shown in FIG. 10, the top of the conductive member 2010 is electrically connected to the transparent conducting layer 105, and the bottom of the conductive member 2010 is electrically connected to the first redistribution layer 208, thereby electrically connecting to the processing chip 110 and the substrate 101. As shown in FIG. 11, the top of the conductive member 2010 is electrically connected to the transparent conducting layer 105, and the bottom of the conductive member 2010 is electrically connected to the second redistribution layer 209, thereby electrically connecting to the processing chip 110 and the substrate 101. As shown in FIGS. 12, 13, and 14, the top of the conductive member 2010 is electrically connected to the transparent conducting layer 105, and the bottom of the conductive member 2010 is electrically connected to the substrate 101.

The conductive member 2010 comprises at least one of a welding wire, a metal pillar, or a conductive through hole. Preferably, the metal pillar is a copper pillar. The conductive through hole can be formed by first providing a through hole on the light shielding layer 102 and then filling the through hole with a conductive material.

In some embodiments, the transparent conducting layer 105 is provided on the upper surface of the one or more optical sensing chips 103, and the transparent conducting layer 105 is electrically connected to the one or more optical sensing chips 103. When the number of the one or more optical sensing chips 103 is a plural number, the transparent conducting layer 105 is provided on the upper surface of each of the optical sensing chips 103, and the transparent conducting layer 105 is electrically connected to the corresponding optical sensing chip 103 thereunder. The transparent conducting layer 105 on an upper surface of the first optical sensing chip 1031 is electrically connected to the first optical sensing chip 1031, and the transparent conducting layer 105 on an upper surface of the second optical sensing chip 1032 is electrically connected to the second optical sensing chip 1032.

Optionally, when the light-transmitting layer 104 is not provided above the one or more optical sensing chips 103, the transparent conducting layer 105 is provided above the one or more optical sensing chips 103, and an upper surface of the transparent conducting layer 105 is flush with the upper surface of the light shielding layer 102.

Optionally, when the light-transmitting layer 104 is provided above the one or more optical sensing chips 103, the transparent conducting layer 105 is arranged below the light-transmitting layer 104, the transparent conducting layer 105 is located between the light-transmitting layer 104 and the one or more optical sensing chips 103, and the upper surface of the light-transmitting layer 104 is flush with the upper surface of the light shielding layer 102.

As an optional embodiment, when the optical sensing module comprises a plurality of optical sensing chips 103, the transparent conducting layer 105 comprises a plurality of transparent conductive segments 1051, and the plurality of transparent conductive segments 1051 are respectively arranged above the plurality of optical sensing chips 103 with one-to-one correspondence.

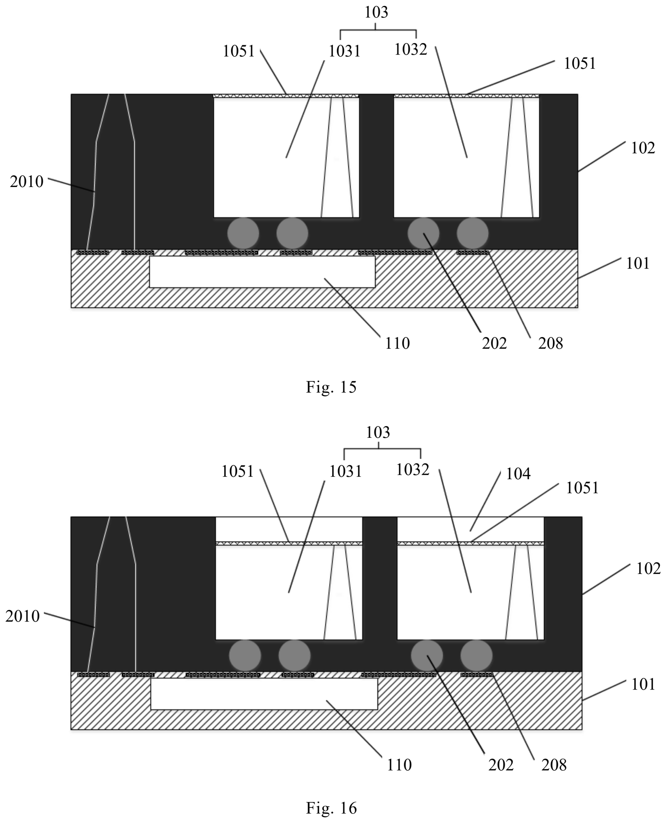

As shown in FIGS. 15-17, when the number of optical sensing chips 103 is a plural number, the transparent conducting layer 105 comprises a plurality of transparent conductive segments 1051, a transparent conductive segment 1051 is provided above each of the optical sensing chips 103, and the transparent conductive segment 1051 is electrically connected to the corresponding optical sensing chip 103 thereunder.

Specifically, as shown in FIGS. 15-17, a lower surface of each transparent conductive segment 1051 among the plurality of transparent conductive segments 1051 is in contact with an upper surface of each optical sensing chip 103 among the plurality of optical sensing chips 103 respectively.

Optionally, as shown in FIG. 15, when the light-transmitting layer 104 is not provided above the plurality of optical sensing chips 103, an upper surface of the plurality of transparent conductive segments 1051 may be flush with the upper surface of the light shielding layer 102.

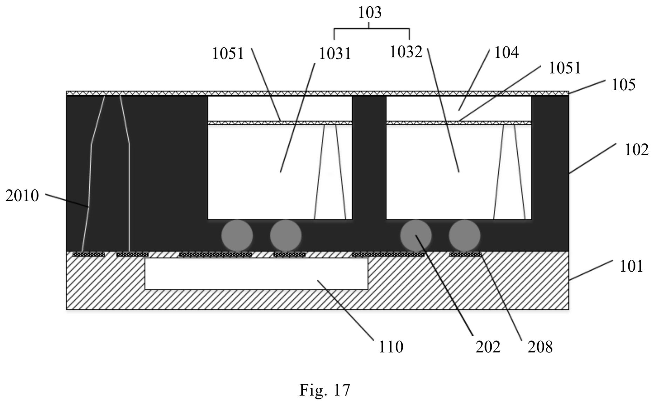

Optionally, as shown in FIGS. 16 and 17, when a plurality of light-transmitting layers 104 are provided above a plurality of optical sensing chips 103, the plurality of transparent conductive segments 1051 are arranged below the plurality of light-transmitting layers 104 respectively, wherein each of the transparent conductive segments 1051 is located between one of the light-transmitting layers 104 and one of the optical sensing chips 103, and an upper surface of the light-transmitting layer 104 is flush with the upper surface of the light shielding layer 102.

Optionally, as shown in FIG. 17, when the plurality of transparent conductive segments 1051 are arranged below the plurality of light-transmitting layers 104 respectively, the transparent conducting layer 105 is further arranged on the plurality of light-transmitting layers 104 and the upper surface of the light shielding layer 102, and the transparent conducting layer 105 is electrically connected to the substrate 101 through the conductive member 2010.

Optionally, the transparent conducting layer 105 comprises at least one of indium tin oxide, indium zinc oxide, a transparent conductive ink, nano silver, or a metal grid. The transparent conducting layer 105 is arranged on the upper surface of the one or more optical sensing chips 103 through a process such as coating, printing, or spraying, and is grounded by interconnection to the one or more optical sensing chips 103, to achieve the electrical shielding function.

In an embodiment of the present disclosure, the transparent conducting layer 105 is arranged to achieve the electrical shielding function of the optical sensing module, further reduce the electrical noise interference, and improve the accuracy of optical signal recognition.

The present disclosure further discloses an electronic device, comprising the optical sensing module according to the above embodiments. The electronic device is an electronic device with a screen module, and may be, e.g., a notebook computer, a mobile phone, a tablet computer, a desktop computer, a gaming device, a vehicle electronic device, or a wearable smart device.

Although the present disclosure has been shown and described with respect to one or more implementations, those skilled in the art will conceive of equivalent modifications and alterations based on reading and understanding of the present specification and the drawings. The present disclosure includes all such alterations and modifications, and is limited only by the scope of the appended claims. In particular, regarding various functions implemented by the above components, a term used to describe such a component is intended to correspond to any component (unless otherwise indicated) that implements a specified function of the component (e.g., functionally equivalent), even if its structure is not identical to the disclosed structure that implements the function in the example implementation of the present specification shown herein.

That is, the above description merely provides embodiments of the present disclosure, and does not limit the patent scope of the present disclosure consequently. Any equivalent structure or equivalent process transformation made by using the content of the specification and the drawings of the present disclosure, such as mutual combination of technical features among the embodiments, or direct or indirect application in other related technical fields, is also included in the scope of patent protection of the present disclosure.

In addition, the terms "first" and "second" are used for descriptive purposes only, and cannot be construed as indicating or implying relative importance or implicitly indicating the number of technical features indicated. Thus, features defined with "first" or "second" may explicitly or implicitly include one or more of the features. In the description of the present disclosure, the "plurality" means two or more than two, unless otherwise explicitly and specifically defined.

In order to enable any person skilled in the art to implement and use the present disclosure, the present disclosure provides the above description. In the above description, various details are enumerated for the purpose of explanation. It should be understood that a person skilled in the art can realize that the present disclosure can still be implemented without using these particular details. In other embodiments, well-known processes will not be elaborated in detail to avoid unnecessary details that make the description of the present disclosure obscure. Therefore, the present disclosure is not intended to be limited to the shown embodiments, but is consistent with a widest range of principles and features disclosed in the present disclosure.

It should be noted that the embodiments described in the present disclosure and/or the technical features in the embodiments may be combined with each other in any way in the case of no conflict, and the combined technical solutions should also be encompassed within the scope of protection of the present disclosure.

It should be understood that the specific examples in the embodiments of the present disclosure are provided only to help those skilled in the art to better understand the embodiments of the present disclosure, rather than limiting the scope of the embodiments of the present disclosure. Those skilled in the art may make various improvements and modifications on the basis of the above embodiments, and these improvements or modifications are all encompassed within the scope of protection of the present disclosure.

While the above description merely provides specific embodiments of the present disclosure, the scope of protection of the present disclosure is not limited to the specific embodiments. Any person skilled in the art can easily conceive of alterations or replacements within the technical scope disclosed in the present disclosure. All these alterations or replacements should be encompassed within the scope of protection of the present disclosure. Therefore, the scope of protection of the present disclosure should be determined by the scope of protection of the claims.

## Claims

1. An optical sensing module, comprising: a substrate, a light shielding layer, one or more optical sensing chips, a light-transmitting layer, and a transparent conducting layer; wherein
the one or more optical sensing chips are arranged above the substrate;
the light-transmitting layer is arranged above the one or more optical sensing chips;
the light shielding layer clads a portion of the one or more optical sensing chips without contacting the substrate and the light-transmitting layer;
the transparent conducting layer is arranged above the light-transmitting layer or/and the transparent conducting layer is arranged above the one or more optical sensing chips, and the transparent conducting layer is electrically connected to a ground wire in the substrate;
the transparent conducting layer is configured to shield an interference signal from the one or more optical sensing chips; and
the one or more optical sensing chips are configured to generate a corresponding electrical signal based on an optical signal transmitting through the transparent conducting layer and the light-transmitting layer and reaching a sensing region.

2. The optical sensing module according to claim 1, wherein a first surface of the one or more optical sensing chips is in contact with a first surface of the substrate, a sensing region on a second surface of the one or more optical sensing chips is in contact with a first surface of the light-transmitting layer, a wiring terminal on the second surface of the one or more optical sensing chips is electrically connected to the substrate through a first welding wire;
the transparent conducting layer is in contact with a second surface of the light-transmitting layer; and
the light shielding layer clads a portion of the light-transmitting layer that excludes the second surface of the light-transmitting layer and an area of the light-transmitting layer in contact with the one or more optical sensing chips, wherein the first surface of the light-transmitting layer is opposite to the second surface of the light-transmitting layer.

3. The optical sensing module according to claim 2, wherein the optical sensing module further comprises: a processing chip, a first surface of the processing chip is in contact with the first surface of the substrate, and the processing chip is electrically connected to the substrate through a second welding wire.

4. The optical sensing module according to claim 2, wherein the transparent conducting layer is electrically connected with the ground wire in the substrate through a circuit board, a third welding wire, or a conductive pillar.

5. The optical sensing module according to claim 2, wherein a surface of the light shielding layer in contact with the transparent conducting layer is flush with the second surface of the light-transmitting layer.

6. The optical sensing module according to claim 5, wherein a side surface of the substrate is in contact with the transparent conducting layer, and a surface of the light shielding layer without contacting the one or more optical sensing chips, the light-transmitting layer, or the substrate is in contact with the transparent conducting layer, wherein the first surface of the substrate is opposite to a second surface of the substrate, and the side surface of the substrate is perpendicular to the first surface and the second surface of the substrate.

7. The optical sensing module according to claim 6, wherein the transparent conducting layer is provided with a through hole for a second wiring terminal located on the side surface of the substrate to run through.

8. The optical sensing module according to claim 2, wherein the first surface of the light-transmitting layer is in contact with the sensing region through a die attach film; and
a light transmittance of the die attach film is greater than or equal to a light transmittance of the light-transmitting layer.

9. The optical sensing module according to claim 1, wherein the optical sensing module further comprises: a processing chip embedded in the substrate or mounted above the substrate in a flipping manner or fixed above the substrate, and the processing chip is electrically connected to the substrate;
the one or more optical sensing chips are mounted on the substrate or/and the processing chip in the flipping manner, the one or more optical sensing chips are electrically connected to the substrate or/and the processing chip thereunder;
the light shielding layer is arranged above the substrate and encapsulates the one or more optical sensing chips and the processing chip, an opening is provided at a position, corresponding to the one or more optical sensing chips on top of the light shielding layer, the opening is configured to expose a photosensitive region of the one or more optical sensing chips to transmit light; and
the light-transmitting layer is arranged in the opening, and the light-transmitting layer is fixed above the one or more optical sensing chips.

10. The optical sensing module according to claim 9, wherein when the processing chip is embedded in the substrate, a top layer of the substrate is provided with a first redistribution layer, and the first redistribution layer is electrically connected to a bonding pad of the processing chip; or
when the processing chip is embedded in the substrate, the top layer of the substrate is provided with a second redistribution layer, the second redistribution layer is electrically connected to a portion of the bonding pad of the processing chip, and other portion of the bonding pad of the processing chip is electrically connected to the substrate through a welding wire; and
one end of the welding wire is connected to the other portion of the bonding pad of the processing chip, and the other end of the welding wire is connected to the second redistribution layer.

11. The optical sensing module according to claim 9, wherein when the processing chip is mounted above the substrate in the flipping manner, a first through silicon via is provided on the processing chip, and is electrically connected to the substrate; or
when the processing chip is fixed above the substrate, the processing chip is electrically connected to the substrate through a welding wire.

12. The optical sensing module according to any one of claims 9 to 11, wherein a second through silicon via is provided on the one or more optical sensing chips, and the second through silicon via is electrically connected to the processing chip or/and the substrate.

13. The optical sensing module according to claim 9, wherein the transparent conducting layer is arranged on an upper surface of the light shielding layer.

14. The optical sensing module according to claim 13, wherein the transparent conducting layer is electrically connected to the processing chip or the substrate through a conductive member extending throughout the light shielding encapsulation layer.

15. The optical sensing module according to claim 14, wherein the conductive member comprises at least one of a welding wire, a metal pillar, or a conductive through hole.

16. The optical sensing module according to claim 9, wherein the optical sensing module comprises a plurality of optical sensing chips, the transparent conducting layer comprises a plurality of transparent conductive segments, and the plurality of transparent conductive segments are respectively arranged above the plurality of optical sensing chips with one-to-one correspondence.

17. The optical sensing module according to claim 1, wherein the one or more optical sensing chips comprise at least one of an ambient light sensor, a proximity sensor, a color temperature sensor, an image sensor, or a light emitting chip.

18. The optical sensing module according to claim 1, wherein the light shielding layer is an opaque black EMC layer or a light-absorbing material layer.

19. An electronic device, comprising the optical sensing module according to any one of claims 1 to 18 and a screen module.
